# EUROPEAN PATENT APPLICATION

(11) **EP 4 531 507 A1**
(43) Date of publication of application: **02.04.2025**
(21) Application number: 24178952.8
(22) Date of filing: 29.05.2024
(51) Int. Cl.: H05K 7/14

(54) **UNINTERRUPTED POWER SUPPLY**

(30) Priority: 28.09.2023 CN 202322669227 U
(71) Applicant: Vertiv Corporation, Columbus, OH 43330 (US)
(72) Inventor: GAO, Cheng, Shenzhen, 518055 (CN); LIN, Chun, Shenzhen, 518055 (CN)
(74) Representative: Morrall, Jonathan Ian McLachlan

(57) **Abstract**

The present disclosure provides an uninterrupted power supply, comprising: a cabinet comprising a wiring area and a module area disposed in parallel along a width direction of the cabinet; an output area, a maintenance switch area, a bypass input area and a main input area disposed in the wiring area along a vertical direction; a first power module, a monitoring module, a bypass module and a second power module disposed in the module area along a vertical direction. The uninterrupted power supply of the present disclosure, while meeting high power density, improves the reliability of a product maximally through innovative layout; meanwhile optimizes the overall layout, greatly reduces floor space and meets the market's requirements for costs for arrangement of uninterrupted power supply equipment on the basis of existing corresponding power equipment; and can realize a multi-scenario configuration of an uninterrupted power supply, with flexible configuration, fast and convenient on-site deployment, which is appropriate for customer's on-site requirements.

## Description

### FIELD

The present application relates to the field of power systems, and in particular to an uninterrupted power supply.

### BACKGROUND

The fierce competition in the market requires continuous optimization of the power systems, which includes increasing the power density, i.e., providing more power output in the same physical space to meet continuously growing power requirements. Meanwhile, it is also necessary to reduce the costs of arrangement to improve competitiveness. The reduction in floor space is an important goal, especially when power systems are deployed in a limited space. This may require utilizing a more compact, efficient uninterrupted power supply to minimize the physical size of the system. With the continuous advancements in technology, a power density of the uninterrupted power supply needs to be continuously increased. This means that an uninterrupted power supply can provide more power output while maintaining a relatively small size, which is very important for applications with high power requirements. In addition to increasing power density, the market also places higher requirements on the reliability of uninterrupted power supply products. The reliability means that the uninterrupted power supply must be able to operate stably during power interruption to protect critical equipment from power interruption.

In summary, the market for power system and uninterrupted power supply is facing multiple challenges and opportunities. The key goals are continuously to increase power density, reduce floor space, and improve reliability, which require continuous innovation and technological advancements to meet market requirements, reduce product costs, and improve performance. This trend will help to meet continuously growing requirements for power systems in different industries and application fields.

### SUMMARY

The technical problem to be solved by the present disclosure is to provide an uninterrupted power supply which can, while meeting high power density, maximally improve the reliability of a product through innovative layout, and meanwhile can greatly reduce floor space and satisfy the market's requirements for arrangement costs of uninterrupted power supply equipment on the basis of existing corresponding power equipment.

To solve the above-mentioned technical problem, a technical solution provided by the present disclosure is: an uninterrupted power supply, comprising: a cabinet, comprising a wiring area and a module area disposed in parallel along a width direction of the cabinet; an output area, a maintenance switch area, a bypass input area, and a main input area disposed in a vertical direction in the wiring area; a first power module, a monitoring module, a bypass module, and a second power module disposed in a vertical direction in the module area.

Further, the uninterrupted power supply further comprises a control wire inlet, which is also disposed in the module area.

Further, the control wire inlet, the first power module, the monitoring module, the bypass module, and the second power module are sequentially stacked in a vertical direction.

Further, the output area, the maintenance switch area, the bypass input area, and the main input area are sequentially stacked in a vertical direction.

Further, the output area and the maintenance switch area is opposite to the first power module in a horizontal direction.

Further, there is further comprised an output copper bar assembly, which comprises a first horizontal output copper bar, a second horizontal output copper bar, a third horizontal output copper bar, a first vertical output copper bar, a second vertical output copper bar, and a third vertical output copper bar; the first horizontal output copper bar, the second horizontal output copper bar, and the third horizontal output copper bar are disposed in the output area; the first vertical output copper bar, the second vertical output copper bar and the third vertical output copper bar are disposed on a side wall of the cabinet that is close to the module area; the first horizontal output copper bar, the second horizontal output copper bar and the third horizontal output copper bar are fixedly connected together with the first vertical output copper bar, the second vertical output copper bar, and the third vertical output copper bar respectively.

Further, the first horizontal output copper bar, the second horizontal output copper bar, and the third horizontal output copper bar extend along a depth direction of the cabinet and are arranged in parallel along a width direction of the cabinet; the first vertical output copper bar, the second vertical output copper bar and the third vertical output copper bar extend along a height direction of the cabinet and are arranged in parallel along the depth direction of the cabinet.

Further, there is further comprised a horizontal neutral wire copper bar and a vertical neutral wire copper bar, the horizontal neutral wire copper bar extending along the depth direction of the cabinet and arranged in parallel to the first horizontal output copper bar, the second horizontal output copper bar and the third horizontal output copper bar along the width direction of the cabinet; the vertical neutral wire copper bar extending along the height direction of the cabinet.

Further, there is further comprised a ground copper bar, which is disposed above the first horizontal output copper bar and extends along the depth direction of the cabinet.

The bypass input area is opposite to the bypass module in a horizontal direction.

Further, there is further comprised a bypass copper bar assembly, which comprises a first bypass copper bar, a second bypass copper bar, a third bypass copper bar, a fourth bypass copper bar, a fifth bypass copper bar and a sixth bypass copper bar; the first bypass copper bar, the second bypass copper bar and the third bypass copper bar are disposed in the bypass input area; the fourth bypass copper bar, the fifth bypass copper bar, and the sixth bypass copper bar are disposed in the module area; the first bypass copper bar, the second bypass copper bar and the third bypass copper bar are fixedly connected together with the fourth bypass copper bar, the fifth bypass copper bar and the sixth bypass copper bar respectively.

Further, the first bypass copper bar, the second bypass copper bar, and the third bypass copper bar extend along the depth direction of the cabinet and are arranged in parallel along the width direction of the cabinet; the fourth bypass copper bar, the fifth bypass copper bar, and the sixth bypass copper bar extend along the width direction of the cabinet and are arranged in parallel along the height direction of the cabinet.

Further, an input end of the bypass module is fixedly connected together with the fourth bypass copper bar, the fifth bypass copper bar, and the sixth bypass copper bar, and an output end of the bypass module is fixedly connected together with the first vertical output copper bar, the second vertical output copper bar and the third vertical output copper bar.

Further, the main input area is opposite to the second power module in a horizontal direction.

Further, there is further comprised a main copper bar assembly, which comprises a first horizontal main copper bar, a second horizontal main copper bar, a third horizontal main copper bar, a first vertical main copper bar, a second vertical main copper bar, and a third vertical main copper bar; the first horizontal main copper bar, the second horizontal main copper bar and the third horizontal main copper bar are disposed in the main input area; the first vertical main copper bar, the second vertical main copper bar and the third vertical main copper bar are disposed between the wiring area and the module area.

Further, the first horizontal main copper bar, the second horizontal main copper bar and the third horizontal main copper bar extend along the depth direction of the cabinet and are arranged in parallel along the width direction of the cabinet; the first vertical main copper bar, the second vertical main copper bar and the third vertical main copper bar extend along the height direction of the cabinet and are arranged in parallel along the depth direction of the cabinet.

Further, there is further comprised a battery wiring assembly, the battery wiring assembly comprising a first anode wiring copper bar, a first cathode wiring copper bar, a second anode wiring copper bar and a second cathode wiring copper bar, the first anode wiring copper bar and the first cathode wiring copper bar are disposed above the output area; the second anode wiring copper bar and the second cathode wiring copper bar are disposed between the wiring area and the module area
Further, the first anode wiring copper bar and the first cathode wiring copper bar extend along the depth direction of the cabinet and are arranged in parallel along the height direction of the cabinet; the second anode wiring copper bar and the second cathode wiring copper bar extend along the height direction of the cabinet and are arranged in parallel along the depth direction of the cabinet.

Further, a top and a bottom of the cabinet are provided with an upper wire inlet and a lower wire inlet, respectively, the upper wire inlet and the lower wire inlet being disposed on the same side of the cabinet as the output area, maintenance switch area, the bypass input area and the main input area.

The beneficial effects of the present disclosure are: the uninterrupted power supply of the present disclosure, while meeting high power density, maximally improves the reliability of a product through innovative layout; meanwhile optimizes the overall layout, greatly reduces floor space and satisfies the market's requirements for arrangement costs of uninterrupted power supply equipment on the basis of existing corresponding power equipment; and can realize a multi-scenario configuration of an uninterrupted power supply, with flexible configuration, fast and convenient on-site deployment, and adaptation to on-site requirements of customers.

### BRIEF DESCRIPTION OF THE DRAWINGS

Figure 1 is a main view of an uninterrupted power supply of the present disclosure in one embodiment;
Figure 2 is a schematic stereoscopic structural diagram of the uninterrupted power supply from a left front view according to an embodiment of the present disclosure;
Figure 3 is a schematic stereoscopic structural diagram of the uninterrupted power supply from a right rear view according to the present disclosure;
Figure 4 is a schematic stereoscopic structural diagram of the uninterrupted power supply from a right front view according to the present disclosure;
Figure 5 is a schematic stereoscopic structural diagram of an input end of a bypass module according to an embodiment of the present disclosure;
Figure 6 is a schematic stereoscopic structural diagram of an output end of the bypass module according to an embodiment of the present disclosure.

The reference symbols include:

| | | | | | |
|---|---|---|---|---|---|
| 100 | cabinet | 110 | output area | 120 | maintenance switch area |
| 130 | bypass input area | 140 | main input area | 150 | control wire inlet |
| 160 | upper wire inlet | 170 | lower wire inlet | 180 | wiring area |
| 190 | module area | 200 | monitoring module | 300 | bypass module |
| 400 | second power module | 500 | first power module | m | main copper bar assembly |
| mA1 | first horizontal main copper bar | mB1 | second horizontal main copper bar | | |
| mC1 | third horizontal main copper bar | mA2 | first vertical main copper bar | | |
| mB2 | second vertical main copper bar | mC2 | third vertical main copper bar | | |
| b | bypass copper bar assembly | bA1 | first bypass copper bar | bB 1 | second bypass copper bar |
| bC1 | third bypass copper bar | bA2 | fourth bypass copper bar | bB2 | fifth bypass copper bar |
| bC2 | sixth bypass copper bar | o | output copper bar assembly | oA1 | first output copper bar |
| oB1 | second horizontal output copper bar | oC1 | third horizontal output copper bar | | |
| N1 | horizontal neutral wire copper bar | PE | ground copper bar | | |
| 520 | battery wiring assembly | 521 | first anode wiring copper bar | | |
| 522 | first cathode wiring copper bar | 523 | second anode wiring copper bar | | |
| 524 | second cathode wiring copper bar | | | | |

### DETAILED DESCRIPTION

In order to clarify the technical problems to be solved, technical solutions and beneficial effects of the present disclosure, the present disclosure will be further described in detail below in conjunction with the accompanying drawings and embodiments. It should be understood that, the specific embodiments described herein are only used to illustrate the present disclosure, but not to limit the present disclosure.

It should be noted that, when an element is referred to as being "fixed to" or "disposed at" another element, it may be either directly or indirectly on the another element. When an element is referred to as being "connected to" another element, it may be either directly or indirectly connected to the another element.

It should be understood that, terms "length", "width", "up", "down", "front", "back", "left", "right", "vertical", "horizontal", "top", "bottom", "inside", "outside" and the like indicate orientation or position relationships based on those illustrated in the appended drawings, aim only to make it convenient to describe the present disclosure and simplify description, but do not indicate or imply that devices or elements as indicated must have specific orientations or be constructed and operated in specific orientations, and therefore cannot be construed as limitations to the present disclosure.

In addition, terms "first" and "second" are used only to describe purposes, but cannot be construed as indicating or implying relative importance or implicitly indicating the number of technical features as indicated. Accordingly, a feature limited by "first" and "second" can explicitly or implicitly include one or more that feature. In the description of the present disclosure, "multiple" means two or more, unless otherwise defined specifically.

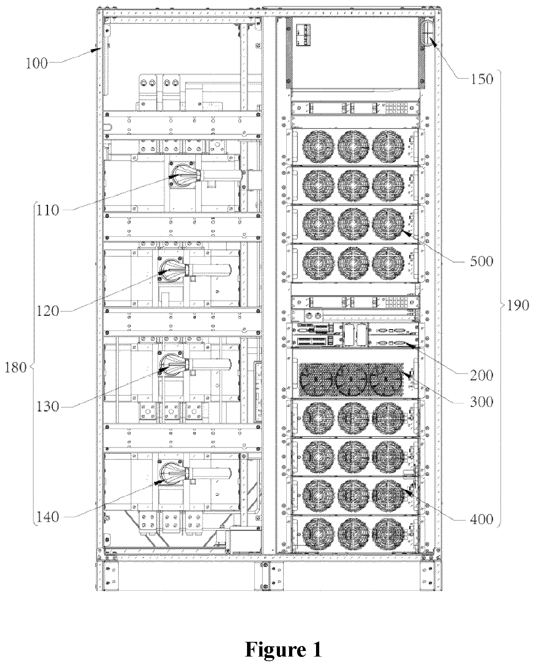

Referring to Figure 1, which is a preferred embodiment of the present disclosure, the uninterrupted power supply comprises: a cabinet 100 comprising a wiring area 180 and a module area 190 disposed in parallel along a width direction of the cabinet 100; an output area 110, a maintenance switch area 120, a bypass input area 130, and a main input area 140 disposed in the wiring area 180 along a vertical direction; a first power module 500, a monitoring module 200, a bypass module 300 and a second power module 400 disposed in the module area 190 along a vertical direction.

The uninterrupted power supply of the present disclosure, while meeting high power density, maximally improves the reliability of a product through innovative layout, at the same time, it optimizes the overall layout, greatly reduces floor space and satisfies the market's requirements for arrangement costs of uninterrupted power supply equipment on the basis of existing corresponding power equipment; and can realize a multi-scenario configuration of an uninterrupted power supply, with flexible configuration, fast and convenient on-site deployment, and adaptation to on-site requirements of customers. The above-mentioned respective constituent parts will be further introduced below in detail, respectively.

The cabinet 100 is generally in the shape of a rectangular box, which is divided into a wiring area 180 for convenient wiring and a module area 190 installed with multiple modules. The wiring area 180 and the module area 190 are disposed in parallel along a width direction of the cabinet 100, that is, the wiring area 180 is disposed on one side inside the cabinet 100, and the module area 190 is disposed on the other side inside the cabinet 100. An upper wire inlet 160 and a lower wire inlet 170 are disposed at the top and bottom of the cabinet 100 respectively, and the upper wire inlet 160 and the lower wire inlet 170 are disposed on the same side of the cabinet 100 as the wiring area 180, that is, the upper wire inlet 160 and the lower wire inlet 170 are disposed in the wiring area 180.

The wiring area 180 may specifically comprise an output area 110, a maintenance switch area 120, a bypass input area 130 and a main input area 140. The output area 110, the maintenance switch area 120, the bypass input area 130 and the main input area 140 are sequentially stacked in the wiring area 180 of the cabinet 100 along a vertical direction from top to bottom.

The module area 190 may specifically comprise a control wire inlet 150, a first power module 500, a monitoring module 200, a bypass module 300 and a second power module 400. The control wire inlet 150 together with the first power module 500, the monitoring module 200, the bypass module 300 and the second power module 400 are sequentially stacked in the module area 190 of the cabinet 100 along a vertical direction from top to bottom. There can be multiple first power modules 500 and multiple second power modules 400, wherein multiple first power modules 500 are stacked together along the vertical direction, and multiple second power modules 400 are also stacked together along the vertical direction. For example, in one embodiment of the present disclosure, there are four first power modules 500 and four second power modules 400 respectively; in another embodiment of the present disclosure, there are six first power modules 500 and four second power modules 400.

More specifically, the first power module 500 is opposite to the output area 110 and the maintenance switch area 120 in a horizontal direction, and the bypass module 300 is opposite to the bypass input area 130 in the horizontal direction, and the second power module 400 is opposite to the main input area 140 in the horizontal direction.

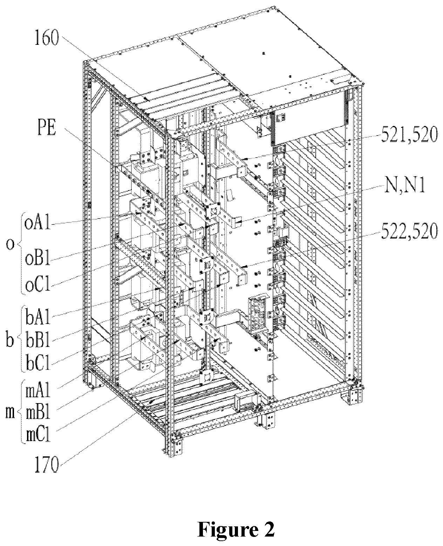

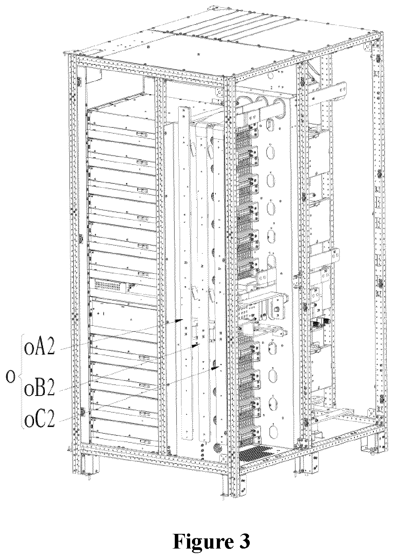

As shown in Figures 2 and 3, in one embodiment of the present disclosure, the uninterrupted power supply further comprises an output copper bar assembly o. The output copper bar assembly o comprises a first horizontal output copper bar oA1, a second horizontal output copper bar oB 1, a third horizontal output copper bar oC1, a first vertical output copper bar oA2, a second vertical output copper bar oB2 and a third vertical output copper bar oC2. The first horizontal output copper bar oA1, the second horizontal output copper bar oB 1 and the third horizontal output copper bar oC1 are fixedly connected together with the first vertical output copper bar oA2, the second vertical output copper bar oB2 and the third vertical output copper bar oC2 respectively.

Specifically, as shown in Figure 2, the first horizontal output copper bar oA1, the second horizontal output copper bar oB1 and the third horizontal output copper bar oC1 are disposed in the output area 110. Each of the first horizontal output copper bar oA1, the second horizontal output copper bar oB 1 and the third horizontal output copper bar oC1 extends along a depth direction of the cabinet 100, that is, the length direction of each of the first horizontal output copper bar oA1, the second horizontal output copper bar oB1 and the third horizontal output copper bar oC1 is same as the depth direction of the cabinet 100. The first horizontal output copper bar oA1, the second horizontal output copper bar oB1 and the third horizontal output copper bar oC1 are disposed in parallel to each other and are arranged along the width direction of the cabinet 100.

Specifically, as shown in Figure 3, the first vertical output copper bar oA2, the second vertical output copper bar oB2 and the third vertical output copper bar oC2 are disposed on a side wall of the cabinet 100 that is close to the module area 190. The first vertical output copper bar oA2, the second vertical output copper bar oB2 and the third vertical output copper bar oC2 extend along a height direction of the cabinet 100, that is, the length direction of each of the first vertical output copper bar oA2, the second vertical output copper bar oB2 and the third vertical output copper bar oC2 is the same as the height direction of the cabinet 100. The first vertical output copper bar oA2, the second vertical output copper bar oB2 and the third vertical output copper bar oC2 are disposed in parallel to each other and are arranged along the depth direction of the cabinet 100.

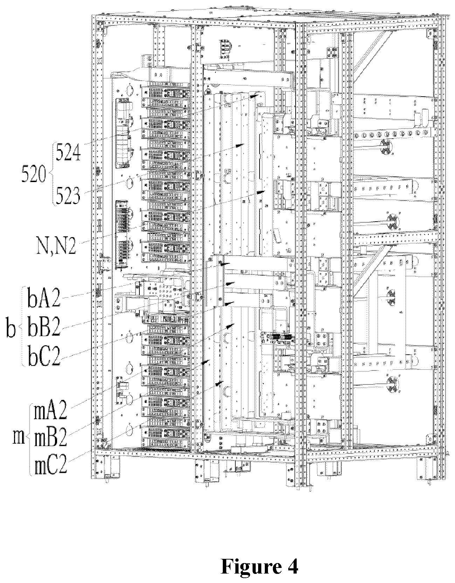

As shown in Figures 2 and 4, in another embodiment of the present disclosure, the uninterrupted power supply further comprises a horizontal neutral wire copper bar N1 and a vertical neutral wire copper bar N2. As shown in Figure 2, the horizontal neutral wire copper bar N1 extends along the depth direction of the cabinet 100, and is arranged in parallel to the first horizontal output copper bar oA1, the second horizontal output copper bar oB1 and the third horizontal output copper bar oC1 along the width direction of the cabinet 100. As shown in Figure 4, the vertical neutral wire copper bar N2 is disposed between the wiring area 180 and the module area 190, and it extends along the height direction of the cabinet 100.

As shown in Figure 2, in other embodiments of the present disclosure, the uninterrupted power supply further comprises a ground copper bar PE. The ground copper bar PE is disposed above the first horizontal output copper bar oA1 and extends along the depth direction of the cabinet 100.

As shown in Figures 2 and 4, the uninterrupted power supply further comprises a bypass copper bar assembly b. The bypass copper bar assembly b comprises a first bypass copper bar bA1, a second bypass copper bar bB1, a third bypass copper bar bC1, a fourth bypass copper bar bA2, a fifth bypass copper bar bB2 and a sixth bypass copper bar bC2. The fourth bypass copper bar bA2, the fifth bypass copper bar bB2 and the sixth bypass copper bar are fixedly connected together with the first bypass copper bar bA1, the second bypass copper bar bB1 and the third bypass copper bar bC1 respectively.

Specifically, the first bypass copper bar bA1, the second bypass copper bar bB1 and the third bypass copper bar bC1 are disposed in the bypass input area 130. The first bypass copper bar bA1, the second bypass copper bar bB1 and the third bypass copper bar bC1 extend along the depth direction of the cabinet 100 and are arranged in parallel along the width direction of the cabinet 100. The fourth bypass copper bar bA2, the fifth bypass copper bar bB2 and the sixth bypass copper bar bC2 are disposed in the module area 190. The fourth bypass copper bar bA2, the fifth bypass copper bar bB2 and the sixth bypass copper bar bC2 extend along the width direction of the cabinet 100 and are arranged in parallel along the height direction of the cabinet 100.

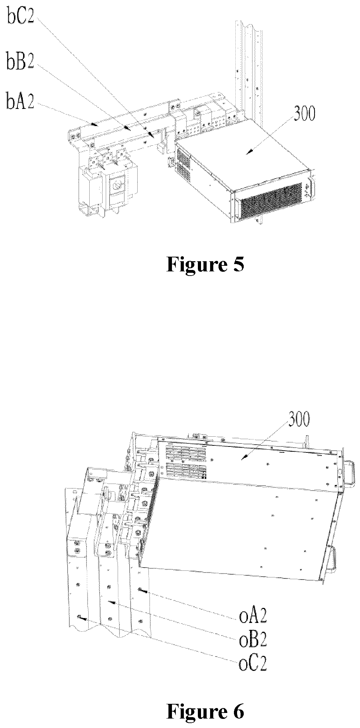

As shown in Figure 5, an input end of the bypass module 300 is fixedly connected together with the fourth bypass copper bar bA2, the fifth bypass copper bar bB2 and the sixth bypass copper bar bC2. As shown in Figure 6, an output end of the bypass module 300 is fixedly connected together with the first vertical output copper bar oA2, the second vertical output copper bar oB2 and the third vertical output copper bar oC2.

As shown in Figures 2 and 4, the uninterrupted power supply further comprises a main copper bar assembly m. The main copper bar assembly m comprises a first horizontal main copper bar mA1, a second horizontal main copper bar mB 1, a third horizontal main copper bar mC1, a first vertical main copper bar mA2, a second vertical main copper bar mB2 and a third vertical main copper bar mC2.

As shown in Figure 2, wherein, the first horizontal main copper bar mA1, the second horizontal main copper bar mB 1 and the third horizontal main copper bar mC1 are disposed in the main input area 140. The first horizontal main copper bar mA1, the second horizontal main copper bar mB 1 and the third horizontal main copper bar mC1 extend along the depth direction of the cabinet 100 and are arranged in parallel along the width direction of the cabinet 100.

As shown in Figure 4, the first vertical main copper bar mA2, the second vertical main copper bar mB2 and the third vertical main copper bar mC2 are disposed between the wiring area 180 and the module area 190. The first vertical main copper bar mA2, the second vertical main copper bar mB2 and the third vertical main copper bar mC2 extend along the height direction of the cabinet 100 and are arranged in parallel along the depth direction of the cabinet 100.

As shown in Figures 2 and 4, the uninterrupted power supply further comprises a battery wiring assembly 520. The battery wiring assembly 520 comprises a first anode wiring copper bar 521, a first cathode wiring copper bar 522, a second anode wiring copper bar 523 and a second cathode wiring copper bar 524.

As shown in Figure 2, the first anode wiring copper bar 521 and the first cathode wiring copper bar 522 are disposed above the output area 110. The first anode wiring copper bar 521 and the first cathode wiring copper bar 522 extend along the depth direction of the cabinet 100 and are arranged in parallel along the height direction of the cabinet.

As shown in Figure 4, the second anode wiring copper bar 523 and the second cathode wiring copper bar 524 are disposed between the wiring area 180 and the module area 190. The second anode wiring copper bar 523 and the second cathode wiring copper bar 524 extend along the height direction of the cabinet 100 and are arranged in parallel along the depth direction of the cabinet 100.

The layout of various modules and copper bars of the switchless uninterrupted power supply is proper, convenient, and safe for wiring; the layout of the main copper bar assembly m, the output copper bar assembly o, the bypass copper bar assembly b, the neutral wire copper bar N, the ground copper bar PE and the battery wiring assembly 520 improves the reliability of the system and the current sharing capacity of equipment.

The above only describes the preferred embodiments of the present disclosure. Those have ordinary skills in the art can make a variety of modifications in specific implementation and application scope based on the idea of the present disclosure. All modifications that do not depart from the concept of the present disclosure fall into the scope of protection of the present disclosure.

## Claims

1. An uninterrupted power supply, **characterized by** comprising:
a cabinet (100) comprising a wiring area (180) and a module area (190) disposed in parallel along a width direction of the cabinet (100);
an output area (110), a maintenance switch area (120), a bypass input area (130) and a main input area (140) disposed in the wiring area (180) along a vertical direction;
a first power module (500), a monitoring module (200), a bypass module (300), and a second power module (400) disposed in the module area (190) along the vertical direction.

2. The uninterrupted power supply according to claim 1, **characterized by** further comprising a control wire inlet (150) disposed in the module area (190).

3. The uninterrupted power supply according to claim 2, **characterized in that**, the control wire inlet (150), the first power module (500), the monitoring module (200), the bypass module (300) and the second power module (400) are sequentially stacked in the vertical direction.

4. The uninterrupted power supply according to claim 1, **characterized in that**, the output area (110), the maintenance switch area (120), the bypass input area (130) and the main input area (140) are sequentially stacked in the vertical direction.

5. The uninterrupted power supply according to claim 1, **characterized in that**, the output area (110) and the maintenance switch area (120) are opposite to the first power module (500) in a horizontal direction.

6. The uninterrupted power supply according to any one of claims 1 to 5, **characterized by** further comprising an output copper bar assembly (o), which comprises a first horizontal output copper bar (oA1), a second horizontal output copper bar (oB1), a third horizontal output copper bar (oC1), a first vertical output copper bar (oA2), a second vertical output copper bar (oB2) and a third vertical output copper bar (oC2); the first horizontal output copper bar (oA1), the second horizontal output copper bar (oB1) and the third horizontal output copper bar (oC1) are disposed in the output area (110); the first vertical output copper bar (oA2), the second vertical output copper bar (oB2) and the third vertical output copper bar (oC2) are disposed on a side wall of the cabinet (100) that is close to the module area (190); the first horizontal output copper bar (oA1), the second horizontal output copper bar (oB1) and the third horizontal output copper bar (oC1) are fixedly connected together with the first vertical output copper bar (oA2), the second vertical output copper bar (oB2) and the third vertical output copper bar (oC2) respectively; and
the first horizontal output copper bar (oA1), the second horizontal output copper bar (oB1) and the third horizontal output copper bar (oC1) extend along a depth direction of the cabinet (100) and are arranged in parallel along the width direction of the cabinet (100); the first vertical output copper bar (oA2), the second vertical output copper bar (oB2) and the third vertical output copper bar (oC2) extend along a height direction of the cabinet (100) and are arranged in parallel along the depth direction of the cabinet (100).

7. The uninterrupted power supply according to claim 6, **characterized by** further comprising a horizontal neutral wire copper bar (N1) and a vertical neutral wire copper bar (N2), the horizontal neutral wire copper bar (N1) extends along the depth direction of the cabinet (100) and is arranged in parallel to the first horizontal output copper bar (oA1), the second horizontal output copper bar (oB1) and the third horizontal output copper bar (oC1) along the width direction of the cabinet (100); the vertical neutral wire copper bar (N2) extends along the height direction of the cabinet (100).

8. The uninterrupted power supply according to claim 6 or 7, **characterized by** further comprising a ground copper bar (PE), which is disposed above the first horizontal output copper bar (oA1) and extends along the depth direction of the cabinet (100).

9. The uninterrupted power supply according to claim 6, **characterized in that**, the bypass input area (130) is opposite to the bypass module (300) in a horizontal direction.

10. The uninterrupted power supply according to claim 9, **characterized by** further comprising a bypass copper bar assembly (b), which comprises a first bypass copper bar (bA1), a second bypass copper bar (bB1), a third bypass copper bar (bC1), a fourth bypass copper bar (bA2), a fifth bypass copper bar (bB2) and a sixth bypass copper bar (bC2); the first bypass copper bar (bA1), the second bypass copper bar (bB1) and the third bypass copper bar (bC1) are disposed in the bypass input area (130); the fourth bypass copper bar (bA2), the fifth bypass copper bar (bB2) and the sixth bypass copper bar (bC2) are disposed in the module area (190); the first bypass copper bar (bA1), the second bypass copper bar (bB1) and the third bypass copper bar (bC1) are fixedly connected together with the fourth bypass copper bar (bA2), the fifth bypass copper bar (bB2) and the sixth bypass copper bar (bC2) respectively;
the first bypass copper bar (bA1), the second bypass copper bar (bB1) and the third bypass copper bar (bC1) extend along the depth direction of the cabinet (100) and are arranged in parallel along the width direction of the cabinet (100); the fourth bypass copper bar (bA2), the fifth bypass copper bar (bB2) and the sixth bypass copper bar (bC2) extend along the width direction of the cabinet (100) and are arranged in parallel along the height direction of the cabinet (100); and
an input end of the bypass module (300) is fixedly connected together with the fourth bypass copper bar (bA2), the fifth bypass copper bar (bB2), and the sixth bypass copper bar (bC2), and an output end of the bypass module (300) is fixedly connected together with the first vertical output copper bar (oA2), the second vertical output copper bar (oB2), and the third vertical output copper bar (oC2).

11. The uninterrupted power supply according to any one of claims 1 to 5, **characterized in that** the main input area (140) is opposite to the second power module (400) in a horizontal direction.

12. The uninterrupted power supply according to claim 11, **characterized by** further comprising a main copper bar assembly (m), which comprises a first horizontal main copper bar (mA1), a second horizontal main copper bar (mB1), a third horizontal main copper bar (mC1), a first vertical main copper bar (mA2), a second vertical main copper bar (mB2) and a third vertical main copper bar (mC2); the first horizontal main copper bar (mA1), the second horizontal main copper bar (mB1) and the third horizontal main copper bar (mC1) are disposed in the main input area (140); the first vertical main copper bar (mA2), the second vertical main copper bar (mB2) and the third vertical main copper bar (mC2) are disposed between the wiring area (180) and the module area (190); and the first horizontal main copper bar (mA1), the second horizontal main copper bar (mB1) and the third horizontal main copper bar (mC1) extend along the depth direction of the cabinet (100) and are arranged in parallel along the width direction of the cabinet (100); the first vertical main copper bar (mA2), the second vertical main copper bar (mB2) and the third vertical main copper bar (mC2) extend along the height direction of the cabinet (100) and are arranged in parallel along the depth direction of the cabinet (100).

13. The uninterrupted power supply according to any one of claims 1 to 5, **characterized by** further comprising a battery wiring assembly (520), the battery wiring assembly (520) comprises a first anode wiring copper bar (521), a first cathode wiring copper bar (522), a second anode wiring copper bar (523) and a second cathode wiring copper bar (524); the first anode wiring copper bar (521) and the first cathode wiring copper bar (522) are disposed above the output area (110); the second anode wiring copper bar (523) and the second cathode wiring copper bar (524) are disposed between the wiring area (180) and the module area (190).

14. The uninterrupted power supply according to claim 13, **characterized in that**, the first anode wiring copper bar (521) and the first cathode wiring copper bar (522) extend along the depth direction of the cabinet (100) and are arranged in parallel along the height direction of the cabinet (100); the second anode wiring copper bar (523) and the second cathode wiring copper bar (524) extend along the height direction of the cabinet (100) and are arranged in parallel along the depth direction of the cabinet (100).

15. The uninterrupted power supply according to claim 1, **characterized in that**, an upper wire inlet (160) and a lower wire inlet (170) are disposed at a top and a bottom of the cabinet (100) respectively, and the upper wire inlet (160) and the lower wire inlet (170) are disposed on the same side of the cabinet (100) as the output area (110), the maintenance switch area (120), the bypass input area (130) and the main input area (140).
